Europäisches Patentamt

European Patent Office

Office européen des brevets

(19)

(11) Numéro de publication : **0 545 809 A1**

(12) # DEMANDE DE BREVET EUROPEEN

(21) Numéro de dépôt : **92403238.6**

(22) Date de dépôt : **01.12.92**

(51) Int. Cl.⁵ : **H01L 23/66, H01L 23/64**

(30) Priorité : **06.12.91 FR 9115165**

(43) Date de publication de la demande :
**09.06.93 Bulletin 93/23**

(84) Etats contractants désignés :
**DE GB IT**

(71) Demandeur : **THOMSON-CSF**
**51, Esplanade du Général de Gaulle**
**F-92800 Puteaux (FR)**

(72) Inventeur : **Cachier, Gérard**
**THOMSON-CSF, SCPI, 50, rue J.P. Timbaud**
**F-92402 Courbevoie Cédex (FR)**

(74) Mandataire : **Albert, Claude et al**
**THOMSON-CSF SCPI B.P. 329, 50, rue J.P.**
**Timbaud**
**F-92402 COURBEVOIE CEDEX (FR)**

(54) **Dispositif de montage de circuits intégrés monolithiques hyperfréquences à très large bande.**

(57)    L'invention concerne un dispositif de montage de circuits intégrés monolithiques hyperfréquences à très large bande.

Les puces de circuit intégré (5) sont montées sur un support en ferrite (20). Le support en ferrite est métallisé uniformément (26) sur sa face inférieure et porte des plages de métallisation (21, 24) sur son autre face. Sur certaines de ces plages (24) servant de plan de masse sont rapportées les puces de circuit intégré (5). Les autres plages (21) servent de relais pour connecter les tensions d'alimentation qui sont appliquées par l'intermédiaire d'un fil de liaison (7′) et d'une capacité à couches minces (10, 11, 12) de découplage portée par la puce. Les plages de masse (24) sont reliées au plan de masse général (26) par des trous métallisés (25). Le fil de liaison (7′) est disposé face à une partie nue du ferrite pour empêcher toute résonance parasite.

L'invention s'applique notamment au montage d'amplificateurs à très large bande en circuits intégrés AsGa.

FIG.4

EP 0 545 809 A1

La présente invention se rapporte à un dispositif de montage de circuits intégrés monolithiques hyperfréquences à très large bande, notamment des circuits AsGa.

Les circuits intégrés monolithiques hyperfréquences à large bande, tels les circuits AsGa, sont très utilisés dans des équipements réclamant de fonctionner sur de très larges bandes, par exemple de 2 à 20 GHz ou plus. Les circuits AsGa améliorent les performances du fait notamment de l'uniformité du gain obtenu et ils permettent une diminution de volume et une réduction des prix de série. Ces avantages sont encore accentués, en utilisation à très large bande passante, par l'emploi de la technique des amplificateurs distribués, permettant simultanément un gain élevé, une très large bande, des coefficients de réflexion en entrée et en sortie faibles, et une bonne isolation entrée-sortie.

Cependant ces circuits intégrés doivent être munis de circuits de découplage des circuits d'alimentation ou de polarisation. Or ces circuits de découplage utilisent des capacités pour découpler les alimentations servant à polariser les amplificateurs et ces capacités doivent être d'autant plus importantes (donc plus grosses) que l'on veut travailler à des fréquences plus basses. Ces capacités prennent donc beaucoup de surface de semi-conducteur, empêchant ainsi une réduction de coût et d'encombrement aussi importante qu'on pourrait l'espérer. En pratique, on ne cherche pas à découpler sur les puces des fréquences inférieures à 5 GHz pour ne pas trop pénaliser la taille de celles-ci et le rendement de fabrication, les capacités réalisées en couches minces n'ayant pas de très bons rendements.

Si l'on veut fonctionner à des fréquences plus basses que 5 GHz, dans le cas des applications à très large bande, une solution connue consiste alors à compléter le découplage par des capacités extérieures de forte valeur réalisées sur un support rapporté portant les circuits intégrés. Ce support peut être un support métallique avec capacités rapportées ou un support silicium conducteur sur lequel on a réalisé des capacités de type MOS (Métal-Oxyde-Semiconducteur).

Un inconvénient de cette solution est toutefois l'apparition d'une résonance due au système capacité sur circuit intégré/fil de liaison/capacité extérieure. La fréquence de résonance ne peut pratiquement être diminuée car cela supposerait une valeur de capacité sur circuit intégré trop élevée et une inductance du fil de liaison très élevée, donc un encombrement trop important et des problèmes de modes parasites pour un fil de liaison long.

L'invention a pour objet de remédier à cet inconvénient en empêchant ce phénomène de résonance de se produire.

Un autre objet de l'invention est un dispositif de montage éliminant l'inconvénient de la solution connue grâce à l'utilisation d'un support en ferrite.

Selon l'invention, il est donc prévu un dispositif de montage de circuits intégrés monolithiques hyperfréquences à très large bande comportant un support sur lequel sont fixées les puces de circuits intégrés qui comprennent des capacités de découplage des alimentations continues desdits circuits, ledit support portant également des moyens de connexion desdites capacités auxdites alimentations, ledit dispositif étant caractérisé en ce que ledit support est en ferrite et en ce que lesdits moyens de connexion comprennent des plages métallisées de connexion sur le support, reliées par des fils de liaison auxdites capacités de découplage, lesdits fils étant disposés en face de parties nues dudit support de ferrite.

L'invention sera mieux comprise et d'autres caractéristiques et avantages apparaîtront à l'aide de la description ci-après et des dessins joints où :

- les figures 1 et 2 sont des vues de dessus et en coupe d'un dispositif de montage dans un circuit hybride selon l'art antérieur ;
- les figures 3 et 4 sont des vues de dessus et en coupe du dispositif de montage selon l'invention ;
- la figure 5 est une vue en coupe grossie d'un détail du dispositif selon l'invention ; et
- la figure 6 est un diagramme illustrant les performances du dispositif selon l'invention.

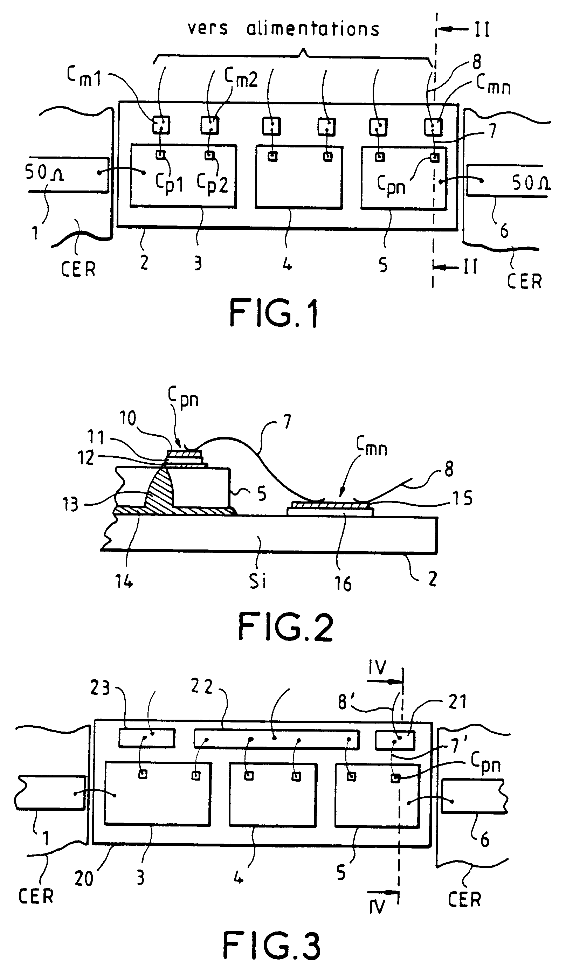

Comme illustré sur les figures 1 et 2, dans une utilisation connue sur support rapporté dans un circuit hybride, les puces de circuit intégré monolithique d'AsGa 3, 4, 5 sont montées sur un support 2 par exemple en silicium conducteur. Le support est disposé entre une ligne d'entrée 1 et une ligne de sortie 2 microstrip d'impédance égale classiquement à 50 $\Omega$, réalisées sur substrat céramique CER. Chaque puce comporte des capacités de découplage $C_{p1}$, $C_{p2}$ ... $C_{pn}$ reliées par des fils de liaison, tel 7 (fil de thermocompression), à des capacités extérieures $C_{m1}$, $C_{m2}$ ... $C_{mp}$ elles-mêmes reliées aux alimentations continues (non représentées) par des connexions, tel le fil 8. Comme on le voit mieux sur la figure 2 qui est une coupe partielle du dispositif de la figure 1 selon la ligne II-II, la puce d'AsGa 5 est montée par l'intermédiaire de sa face inférieure métallisée 14 sur le support en silicium conducteur 2. La capacité $C_{pn}$ réalisée sur la puce 5 comporte une couche diélectrique 11 comprise entre deux couches métalliques 10 et 12, toutes ces couches étant réalisés en technologie couches minces. La couche conductrice 12 est reliée à la couche 14 servant de masse par un trou métallisé 13. La capacité extérieure $C_{mn}$ est une capacité du type MOS comportant une couche métallique 15, une couche d'oxyde $SiO_2$ 16 et une couche semiconducteur constituée par le support 2 servant de masse. La couche 10 et la couche 15 sont reliées par un fil de liaison 7 (fil de thermocompression).

Le système capacité $C_{pn}$/fil de liaison 7 d'induc-

tance L/capacité $C_{mn}$ présente une résonance à la fréquence $f_r$ :

$$f_r = \frac{1}{2\pi} \sqrt{L \cfrac{1}{\cfrac{C_{pn} C_{mn}}{C_{pn} + C_{mn}}}}$$

En pratique, à titre d'exemple :

L     = 0,1 nH
$C_{pn}$  = 20 pF
$C_{mn}$  = 200 pF
d'où :
     $f_r$ = 3,5 GHz

Cette valeur est très difficile à diminuer car cela supposerait une capacité $C_{pn}$ très élevée, solution éliminée en pratique pour les raisons déjà mentionnées, et une inductance L très élevée qui entraînerait des problèmes d'encombrement et de modes parasites pour un fil de thermocompression long.

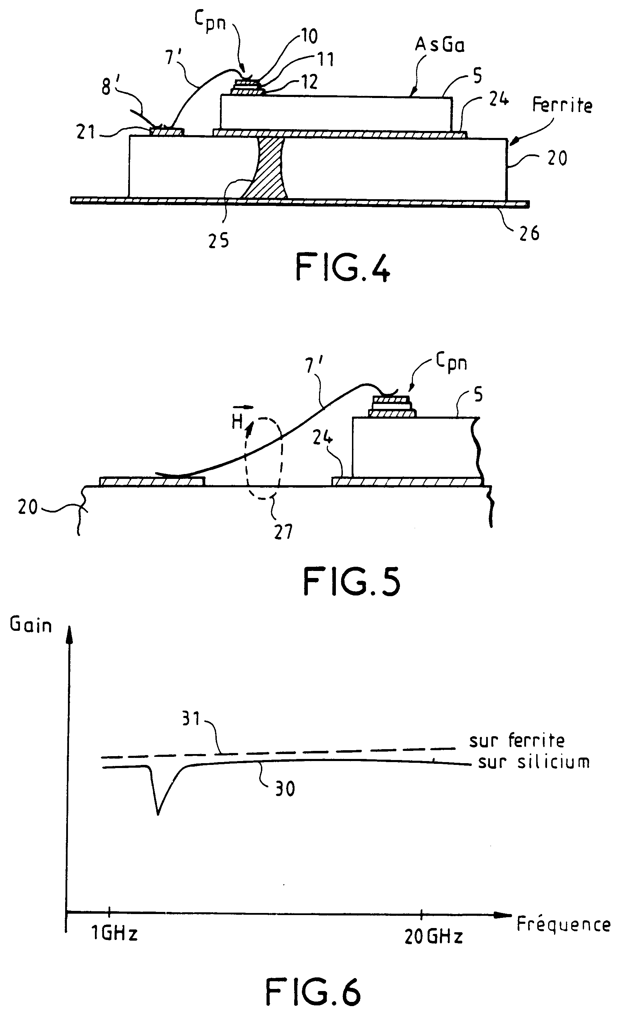

L'invention propose de remplacer le support 2 en silicium par un support 20 en ferrite comme représenté sur la figure 3 vue de dessus et la figure 4 en coupe selon la ligne IV-IV de la figure 3. Les mêmes numéros de référence renvoient aux mêmes éléments que sur les figures 1 et 2. Le support 20 a la forme d'une plaquette d'une épaisseur de quelques centaines de micromètres et est par exemple en un ferrite de nickel pur, possédant une faible perméabilité et une fréquence de résonance (sans champ magnétique) maximum (2 GHz). La plaquette 20 a une métallisation uniforme 26 servant de plan de masse général sur une de ses faces (la face inférieure sur le dessin) et plusieurs plages de métallisation sur son autre face : certaines de ces plages, telle la plage 24 servent de plan de masse pour les puces 3, 4, 5 qui y sont montées et les autres 21, 22, 23 (une seule ou plusieurs selon les cas) servent de plages de connexion pour les tensions d'alimentation à appliquer. Ainsi la plage 21 est reliée à la capacité $C_{pn}$ par le fil de liaison 7' et à l'alimentation par un fil 8'.

Chaque plage de masse supérieure, telle 24, sur laquelle est rapportée une puce AsGa est reliée au plan de masse général 26 par un (ou plusieurs) trou métallisé 25.

La figure 5 montre un aspect important de l'invention. Sur cette figure 5 est représentée grossie une partie de la coupe de la figure 4. Comme on le voit, le fil 7'est disposé face à une partie du ferrite 20 qui apparaît nu. Ceci a son importance car cela permet le couplage entre le champ magnétique H créé autour du fil 7'(comme on l'a matérialisé par une ligne de force 27) et le matériau ferrite. Grâce à ce couplage et à l'absorption qui en résulte, on empêche toute résonance de se produire dans le fil 7'.

La figure 6 illustre les performances obtenues. La courbe 30 montre la variation du gain en fonction de la fréquence dans un équipement selon l'art antérieur et la courbe 31 montre la variation du gain pour le même équipement mais avec un support de ferrite selon l'invention.

On voit qu'on a ainsi supprimé des résonances parasites gênantes sur une très large bande descendant bien au-dessous de 3 GHz.

Bien entendu, l'exemple de réalisation décrit n'est nullement limitatif de l'invention.

## Revendications

1. Dispositif de montage de circuits intégrés monolithiques hyperfréquences à très large bande comportant un support (2) sur lequel sont fixées les puces (3, 4, 5) de circuits intégrés qui comprennent des capacités de découplage des alimentations continues desdits circuits, ledit support portant également des moyens de connexion desdites capacités auxdites alimentations, ledit dispositif étant caractérisé en ce que ledit support (20) est en ferrite et en ce que lesdits moyens de connexion comprennent des plages métallisées de connexion sur le support, reliées par des fils de liaison (7') auxdites capacités de découplage ($C_{p1}$ à $C_{pn}$), lesdits fils étant disposés en face de parties nues dudit support de ferrite.

2. Dispositif selon la revendication 1, caractérisé en ce que ledit support de ferrite (20) comprend sur une première face une métallisation uniforme (26) pour former un plan de masse général et sur la face opposée une pluralité de plages de métallisation (21, 22, 23, 24) dont certaines (24) servent de plan de masse pour les puces (3, 4, 5) qui y sont rapportées et sont reliées audit plan de masse général (26) par au moins un trou métallisé (25) traversant le support en ferrite (20), et dont les autres (21, 22, 23) constituent lesdites plages métallisées de connexion.

3. Dispositif selon l'une des revendications 1 ou 2, caractérisé en ce que ledit ferrite est un ferrite de nickel pur à faible perméabilité.

FIG.1

FIG.2

FIG.3

FIG.4

FIG.5

FIG.6

Office européen
des brevets

**RAPPORT DE RECHERCHE EUROPEENNE**

Numero de la demande

EP    92 40 3238

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | PATENT ABSTRACTS OF JAPAN vol. 15, no. 330 (E-1103)22 Août 1991 & JP-A-31 24 050 ( SHARP CORP ) 27 Mai 1991 * abrégé * | 1 | H01L23/66 H01L23/64 |
| | --- | | |
| A | PATENT ABSTRACTS OF JAPAN vol. 13, no. 578 (E-864)20 Décembre 1989 & JP-A-1 241 848 ( MATSUSHITA ELECTRIC IND ) 26 Septembre 1989 * abrégé * | 1 | |
| | --- | | |
| A | FR-A-2 584 865 (COMPAGNIE D'INFORMATIQUE MILITAIRE SPATIALE ET AERONAUTIQUE) * page 6, ligne 9 - ligne 33; figure 3 * | 1 | |
| | --- | | |
| A | PATENT ABSTRACTS OF JAPAN vol. 13, no. 031 (E-707)24 Janvier 1989 & JP-A-63 232 421 ( NIPPON PAINT CO ) 28 Septembre 1988 * abrégé * | 1 | DOMAINES TECHNIQUES RECHERCHES (Int. Cl.5) |
| | --- | | |
| A | EP-A-0 001 890 (SECRETARY OF STATE FOR DEFENCE OF THE UNITED KINGDOM) * page 7, ligne 13 - page 11, ligne 6; figures 1,2 * | 1 | H01L |
| | --- | | |
| A | FR-A-2 620 275 (THOMSON HYBRIDES ET MICROONDES) * abrégé; figure 1 * | 2 | |
| | ----- | | |

Le présent rapport a été établi pour toutes les revendications

| Lieu de la recherche | Date d'achèvement de la recherche | Examinateur |
|---|---|---|
| BERLIN | 08 MARS 1993 | LE MINH I. |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
................................................................
& : membre de la même famille, document correspondant

EPO FORM 1503 03.82 (P0402)